(19) **Europäisches Patentamt / European Patent Office / Office européen des brevets**

(11) **EP 2 148 373 B1**

(12) **FASCICULE DE BREVET EUROPEEN**

(45) Date de publication et mention
de la délivrance du brevet:
**11.11.2015 Bulletin 2015/46**

(51) Int Cl.:
***H01L 29/10*** (2006.01)     ***H01L 21/8238*** (2006.01)
***H01L 21/84*** (2006.01)

(21) Numéro de dépôt: **09165568.8**

(22) Date de dépôt: **15.07.2009**

(54) **Procédé pour contraindre simultanément en tension et en compression les canaux de transistors NMOS et PMOS respectivement**

Verfahren zum jeweils gleichzeitigen Versetzen in Spannung und Kompression von Kanälen von NMOS- und PMOS-Transistoren

Method for applying simultaneous tensile and compressive stress to NMOS and PMOS transistor channels respectively

(84) Etats contractants désignés:
**AT BE BG CH CY CZ DE DK EE ES FI FR GB GR HR HU IE IS IT LI LT LU LV MC MK MT NL NO PL PT RO SE SI SK SM TR**

(30) Priorité: **21.07.2008 FR 0854946**

(43) Date de publication de la demande:
**27.01.2010 Bulletin 2010/04**

(73) Titulaire: **Commissariat à l'Énergie Atomique et aux Énergies Alternatives 75015 Paris (FR)**

(72) Inventeurs:
• **Lamrani, Younes**
  **01000 Bourg-en-Bresse (FR)**
• **Barbe, Jean-Charles**
  **38160 Izeron (FR)**
• **Kostrzewa, Marek**
  **38100 Grenoble (FR)**

(74) Mandataire: **Ilgart, Jean-Christophe et al BREVALEX 95, rue d'Amsterdam 75378 Paris Cedex 8 (FR)**

(56) Documents cités:
**US-A1- 2004 132 267     US-A1- 2005 082 531
US-A1- 2006 214 232     US-A1- 2007 254 423
US-B1- 6 764 908     US-B2- 7 223 994
US-B2- 7 262 087**

• **CHEN-YU HSIEH ET AL: "Measurement of Channel Stress Using Gate Direct Tunneling Current in Uniaxially Stressed nMOSFETs", IEEE ELECTRON DEVICE LETTERS, IEEE SERVICE CENTER, NEW YORK, NY, US, vol. 28, no. 9, 1 septembre 2007 (2007-09-01), pages 818-820, XP011190974, ISSN: 0741-3106**

**Description**

**DOMAINE TECHNIQUE**

La présente invention se rapporte au domaine des circuits intégrés, et plus particulièrement à celui des transistors, et a pour but de présenter un procédé de réalisation d'un dispositif microélectronique doté de plusieurs transistors aux performances électriques améliorées, et en particulier dans lequel, sur un même substrat, un ou plusieurs transistors sont contraints en tension tandis qu'un ou plusieurs autres transistors sont contraints en compression.

**ÉTAT DE LA TECHNIQUE ANTÉRIEURE**

Dans le transistor MOS (MOS pour Metal Oxide Semiconductor), deux réservoirs de porteurs de charges : la source et le drain, sont séparés par une barrière de potentiel formée par le canal. Cette barrière est contrôlée par une grille d'une longueur qui peut varier de plusieurs nanomètres à plusieurs dizaines de nanomètres. La grille est séparée du canal par un diélectrique de grille.

On cherche constamment à diminuer la dimension des transistors. Dans les procédés existants de réalisation de dispositifs microélectroniques, la mise en oeuvre d'une couche de silicium contraint sur un substrat SOI (SOI pour « Silicon on Insulator » ou silicium sur isolant), a permis d'augmenter à la fois la mobilité des porteurs grâce à l'effet d'une contrainte mécanique sur un matériau semi-conducteur et la densité d'intégration grâce à une isolation électrique du transistor. L'introduction de contraintes mécaniques dans le canal de conduction permet d'améliorer très fortement la mobilité des porteurs, et donc les performances électriques des transistors.

Une contrainte mécanique bi-axiale en tension peut permettre d'augmenter de manière importante la mobilité des électrons pour les transistors NMOS.

Pour les transistors PMOS, une contrainte en compression permet quant à elle d'obtenir un gain en mobilité des trous.

Actuellement, il existe différentes méthodes pour permettre de contraindre un canal de transistor. On peut utiliser un substrat standard avec un canal contraint en cours de fabrication du transistor. On peut également utiliser un substrat modifié précontraint sur lequel on réalise une zone de canal.

Afin d'améliorer la mobilité des porteurs de charge à la fois dans les transistors NMOS et PMOS, des procédés permettant de former, sur un même substrat, une ou plusieurs zones semi-conductrices contraintes en tension et une ou plusieurs zones semi-conductrices contraintes en compression sont apparus.

Le document US 7 262 087 B2 décrit un procédé pour réaliser un dispositif microélectronique, dans lequel des régions NFET sont contraintes en tension tandis que des régions PFET sont contraintes en compression. Le dispositif microélectronique est formé à partir d'un substrat sur lequel on réalise un premier empilement comprenant une première couche de matériau diélectrique contrainte en compression, sur laquelle est formée une première couche de matériau semi-conducteur placée sur la première couche de matériau diélectrique. La première couche de matériau diélectrique permet d'induire une contrainte en tension sur la première couche de matériau semi-conducteur.

A coté de ce premier empilement, un deuxième empilement est réalisé. Ce deuxième empilement est formé d'une deuxième couche de matériau diélectrique contrainte en tension formée sur le substrat et d'une deuxième couche de matériau semi-conducteur placée sur la couche de matériau diélectrique contrainte en tension. La deuxième couche diélectrique transfère des contraintes en compression à la deuxième couche de matériau semi-conducteur. Un tel procédé nécessite la réalisation d'une zone diélectrique enterrée contrainte en tension et d'une zone diélectrique enterrée contrainte en compression.

Le document US 7 223 994 B2 divulgue, quant à lui, un procédé dans lequel on fait croitre, sur un substrat, une couche contrainte en compression de SiGe ou de Si:C sur laquelle on dépose une couche de matériau semi-conducteur. Après une étape de gravure permettant de définir un ilot comportant un motif semi-conducteur contraint en tension, on dépose une autre couche à base de SiGe, cette fois contrainte en tension, puis on dépose ensuite une couche de matériau semi-conducteur. Une étape de gravure permet de définir un autre ilot semi-conducteur, contraint en compression.

Le document US 7 091 095 B2, divulgue quant à lui, une réalisation d'un dispositif comportant des motifs de matériau semi-conducteur dans lequel la conduction des électrons est favorisée et des motifs de matériau semi-conducteur dans lequel la conduction des trous est également favorisée. Un tel procédé de réalisation comprend la croissance, côte à côte, d'une zone à base de SiGe contrainte en tension et d'une autre zone à base de SiGe contrainte en compression.

Un tel procédé est complexe et long à mettre en oeuvre dans la mesure où il nécessite plusieurs étapes d'épitaxies successives différentes.

Il se pose le problème de trouver un nouveau procédé de réalisation d'un dispositif microélectronique comprenant une ou plusieurs zones semi-conductrices contraintes en tension et d'une ou plusieurs zones semi-conductrices contraintes en compression, qui ne comporte pas les inconvénients mentionnés ci-dessus.

## EXPOSÉ DE L'INVENTION

L'invention concerne en particulier un procédé de réalisation d'un dispositif microélectronique comprenant une ou plusieurs zones semi-conductrices contraintes en tension et une ou plusieurs zones semi-conductrices contraintes en compression, qui ne comporte pas les inconvénients mentionnés ci-dessus, dans lequel on forme des tranchées dans une couche précontrainte au-dessus de laquelle des zones semi-conductrices ont été préalablement réalisées, les dimensions et l'agencement des tranchées par rapport aux zones semi-conductrices, ainsi que la dimension critique des zones semi-conductrices étant prévues de manière à former au moins une zone semi-conductrice contrainte en compression et au moins une zone semi-conductrice contrainte en tension.

Selon un premier aspect, l'invention concerne un procédé de réalisation d'un dispositif microélectronique selon la revendication 1.

Selon un autre aspect, l'invention concerne un procédé de réalisation d'un dispositif microélectronique selon la revendication 2.

Selon cet autre aspect, la deuxième zone semi-conductrice peut éventuellement avoir une dimension critique inférieure ou égale à la longueur limite Lc. De par l'espace d prévu entre les tranchées et la deuxième zone semi-conductrice, le type de contrainte auquel la deuxième zone semi-conductrice est soumise est différent de celui auquel la première zone semi-conductrice est soumise.

La profondeur des tranchées peut être prévue de l'ordre de la demi-longueur de la zone semi-conductrice.

La profondeur des tranchées peut être prévue inférieure à la dimension critique de ladite deuxième zone semi-conductrice.

Parmi lesdites tranchées au moins une autre tranchée est réalisée dans le prolongement d'un deuxième flanc de ladite première zone semi-conductrice, opposé audit premier flanc.

Selon une possibilité, la deuxième zone semi-conductrice et la première zone semi-conductrice peuvent reposer sur un même bloc gravé à l'étape b) dans ledit empilement, avec au moins deux desdites tranchées situées de part et d'autre dudit même bloc gravé.

Selon une possibilité, lesdites tranchées peuvent être réalisées dans une partie de l'épaisseur de la couche précontrainte.

Selon une variante, lesdites tranchées peuvent être réalisées dans toute l'épaisseur de la couche précontrainte.

La profondeur des tranchées peut être prévue en fonction du niveau de contrainte que l'on souhaite appliquer à la première zone semi-conductrice et à la deuxième zone semi-conductrice.

Ladite couche précontrainte peut être une contrainte bi-axiale dans un plan orthogonal au plan principal du substrat.

Selon une possibilité, ladite couche précontrainte peut être à base d'un matériau diélectrique tel que du $Si_3N_4$.

Ledit empilement peut comprendre une couche d'adhérence entre la couche précontrainte et la couche semi-conductrice.

Selon une mise en oeuvre particulière, ladite couche semi-conductrice peut être précontrainte ou avoir une contrainte intrinsèque.

Ladite couche précontrainte peut être située sur une couche de matériau diélectrique reposant sur une couche de support semi-conductrice.

Le procédé peut comprendre en outre : le remplissage des tranchées à l'aide d'un matériau isolant.

Le procédé peut comprendre également : la formation sur une ou plusieurs ou sur l'ensemble desdites zones semi-conductrices d'au moins une zone de diélectrique de grille et d'au moins une grille sur la zone de diélectrique de grille.

Ainsi, des transistors MOS peuvent être formés sur la première zone semi-conductrice et sur la deuxième zone semi-conductrice.

Ladite couche de matériau diélectrique peut être une couche précontrainte en tension, suite à l'étape b), ladite première zone semi-conductrice étant une couche contrainte en tension, ladite deuxième zone semi-conductrice étant contrainte en compression.

## BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels :

- les figures 1A-1C, illustrent un exemple de procédé selon l'invention, de réalisation d'un dispositif microélectronique doté de zones semi-conductrices subissant des contraintes différentes sur un même substrat,
- la figure 2 illustre une variante de procédé de réalisation d'un procédé suivant l'invention,

- les figures 3 à 5 illustrent, des exemples de dispositifs microélectroniques obtenus à l'aide d'un procédé selon l'invention,
- les figures 6A à 6B, et 7 montrent, des résultats de simulations sous forme de champs de contrainte exercées sur les zones semi-conductrices de dispositifs suivant l'invention,
- les figures 8A-8D donnent des exemples de courbes d'évolution de la contrainte moyenne exercée sur une zone semi-conductrice obtenue à l'aide d'un procédé suivant l'invention, en fonction de sa dimension critique, pour différentes valeurs d'épaisseur de cette zone et d'un empilement de couches sous-jacentes à cette zone et comportant au moins une couche précontrainte,
- les figures 9A-9B donnent respectivement un exemple de structure et un exemple de structure équivalente, utilisés pour la détermination d'une longueur limite Lc, par rapport à laquelle la dimension critique des zones semi-conductrices d'un dispositif microélectronique mis en oeuvre suivant l'invention est prévue,
- la figure 10 illustre une inversion du type de contrainte, de la tension vers la compression, exercée sur une zone semi-conductrice obtenue à l'aide d'un procédé suivant l'invention, en fonction de la dimension critique choisie pour cette zone semi-conductrice.

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

## EXPOSÉ DÉTAILLÉ DE MODES DE RÉALISATION PARTICULIERS

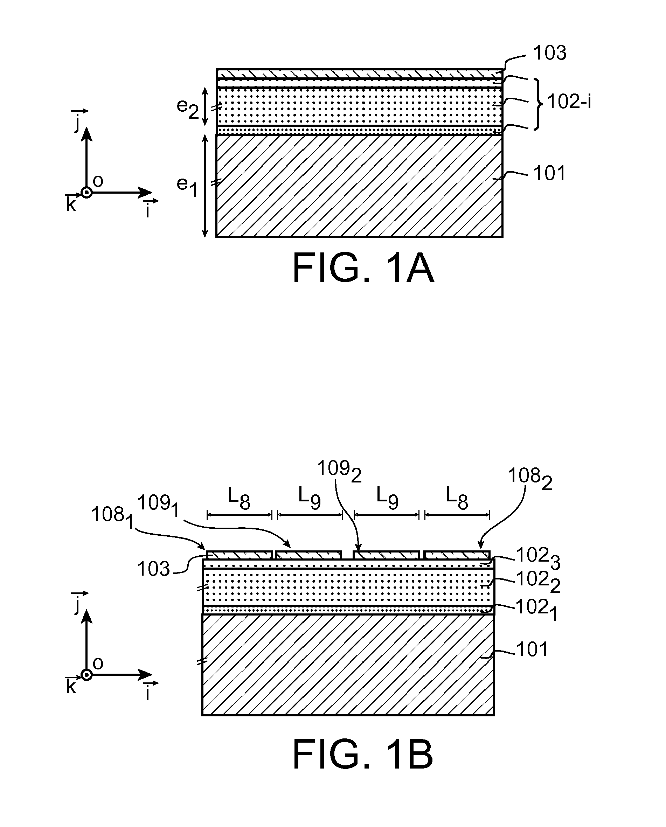

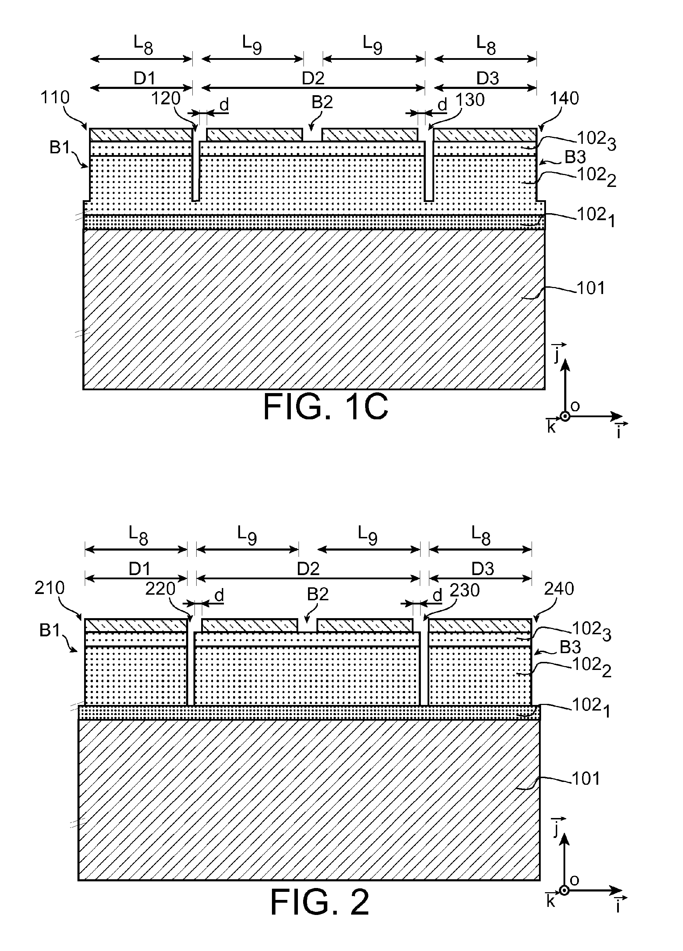

Un exemple de procédé suivant l'invention, de réalisation d'un dispositif microélectronique comprenant au moins une zone semi-conductrice contrainte en tension et au moins une autre zone semi-conductrice contrainte en compression, va à présent être donné, en liaison avec les figures 1A-1C et 2.

Le matériau ou composant de départ du procédé (figure 1A) peut être un substrat formé d'une première couche 101 de matériau semi-conducteur, par exemple à base de Si.

La première couche 101 est prévue pour servir de support mécanique et a une épaisseur $e_1$, de préférence très grande par rapport à l'épaisseur de l'ensemble des autres couches du dispositif. La couche 101 peut avoir une épaisseur par exemple de l'ordre d'une dizaine de micromètres ou de plusieurs dizaines de micromètres.

Au dessus de la couche 101 de support, figure au moins une couche dite « précontrainte ». Cette couche « précontrainte » peut avoir une contrainte intrinsèque qui peut être bi-axiale dans un plan perpendiculaire à la surface de la première couche 101.

La couche précontrainte peut être formée par exemple par CVD (CVD pour « Chemical Vapour Deposition ») ou LPCVD (LPCVD pour « Low Pressure Chemical Vapour Deposition »). La couche précontrainte peut être par exemple à base d'un matériau semi-conducteur tel que du SiGe.

Selon une autre possibilité, la couche précontrainte peut être à base d'un matériau diélectrique tel que du $Si_xN_y$ ou de l'$Al_2O_3$.

Dans un cas où la couche précontrainte est à base de $Si_xN_y$, la contrainte peut être ajustée en fonction de la proportion de Si. La contrainte exercée par la couche précontrainte peut être d'au moins 100 MPa, par exemple de l'ordre de 1 GPa.

Une couche isolante 102 peut être formée sur la première couche 101 de support à base de matériau semi-conducteur. La couche isolante 102 peut être formée de plusieurs couches, dont ladite couche précontrainte.

La couche isolante 102 peut être formée d'une première couche $102_1$ à base de matériau diélectrique, par exemple du $SiO_2$, reposant sur la première couche 101 de matériau semi-conducteur. La première couche $102_1$ à base de matériau diélectrique peut avoir une épaisseur par exemple de l'ordre de plusieurs nanomètres, par exemple de l'ordre de 10 nanomètres.

La première couche $102_1$ peut être prévue à base d'un matériau diélectrique pour favoriser l'adhésion d'un empilement de couches sur la première couche 101 de matériau semi-conducteur. La première couche $102_1$ à base de matériau diélectrique tel que du $SiO_2$ peut ainsi servir de couche d'adhérence ou de tenue mécanique, et peut servir à lier la couche précontrainte $102_2$, par exemple à base de $Si_3N_4$, à la couche 101 de support semi-conductrice.

La couche isolante 102 peut être également formée d'une deuxième couche $102_2$ à base de matériau diélectrique, par exemple du $Si_3N_4$, reposant sur la première couche 101 de matériau semi-conducteur. La deuxième couche $102_2$ à base de matériau diélectrique, peut être ladite couche précontrainte. La contrainte dans la deuxième couche $102_2$ de matériau diélectrique est une contrainte intrinsèque qui peut être bi-axiale dans un plan perpendiculaire au plan principal du substrat (le plan principal du substrat étant défini dans toute la description et sur la figure 1A, par un plan parallèle au plan $[O;\vec{i};\vec{k}]$ d'un repère orthogonal $[O;\vec{i};\vec{j};\vec{k}]$). La couche de matériau diélectrique $102_2$ précontrainte, est

soumise à une contrainte d'un type donné, par exemple une contrainte en tension. La contrainte à laquelle est soumise la couche de matériau diélectrique $102_2$ peut être par exemple de l'ordre de 1,5 GPa.

La couche isolante 102 peut également comprendre une troisième couche $102_3$ à base de matériau diélectrique, par exemple du $SiO_2$, reposant sur la première couche 101 de matériau semi-conducteur. La troisième couche $102_3$ peut être choisie pour ses propriétés d'isolation électrique et avoir une épaisseur par exemple de l'ordre d'une dizaine de nanomètres, par exemple de l'ordre de 16 nanomètres.

L'épaisseur $e_2$ de la deuxième couche de matériau diélectrique $102_2$ précontrainte est prévue de préférence supérieure à l'épaisseur des première et troisième couches $102_1$ et $102_3$ de matériau diélectrique. La deuxième couche de matériau diélectrique $102_2$ peut avoir une épaisseur $e_2$ au moins 10 fois supérieure à celle des première et troisième couches $102_1$ et $102_3$ de matériau diélectrique. La couche précontrainte $102_2$ peut avoir une épaisseur comprise par exemple entre 50 nanomètres et 200 nanomètres, par exemple de l'ordre de 120 nanomètres.

Sur la couche isolante 102 repose une fine couche semi-conductrice 103, par exemple de l'ordre de 10 nanomètres d'épaisseur dans laquelle plusieurs zones actives sont destinées à être formées. La couche précontrainte $102_2$ peut avoir une épaisseur prévue 5 à 10 fois l'épaisseur de ladite fine couche semi-conductrice 103.

Un substrat de type SOIM (SOIM pour « Silicon on Insulating Multiple layer ») comportant plusieurs couches diélectriques entre une couche semi-conductrice de support et une couche semi-conductrice dans laquelle des zones actives sont destinées à être réalisées, peut être ainsi formé (figure 1A).

L'épaisseur de la couche 101 de support est prévue de manière à assurer une rigidité mécanique suffisante pour limiter la relaxation de la couche précontrainte $102_2$ par une autre voie que la gravure.

Afin de maintenir un état de contrainte important, l'épaisseur $e_2$ de la couche précontrainte $102_2$ est de préférence faible devant l'épaisseur $e_1$ de la couche 101 du substrat, par exemple au moins 20 fois inférieure à l'épaisseur de la couche 101 du substrat.

Ensuite (figure 1B), on effectue une gravure de la couche semi-conductrice 103 afin de réaliser plusieurs ilots semi-conducteurs ou zones semi-conductrices $108_1$, $108_2$, $109_1$, $109_2$, disjointes à partir de la couche semi-conductrice 103. Les zones semi-conductrices $108_1$, $108_2$, $109_1$, $109_2$, sont destinées à former des zones actives de transistors. Parmi les zones semi-conductrices $108_1$, $108_2$, $109_1$, $109_2$, réalisées, figurent une première zone $108_1$, et une deuxième zone $108_2$, formées avec une première dimension critique $L_8$, ainsi qu'une troisième zone $109_1$, et une quatrième zone $109_2$, formées avec une deuxième dimension critique $L_9$, différente de la première dimension critique $L_8$.

La première dimension critique $L_8$, est choisie inférieure à une distance appelée « longueur limite » Lc prédéterminée.

La première dimension critique $L_8$ est par exemple comprise entre une ou plusieurs dizaines de nanomètres et une dizaine de fois l'épaisseur de la couche semi-conductrice 103. La première dimension critique $L_8$ peut être par exemple comprise entre 40 et 200 nanomètres et par exemple de l'ordre de 70 nanomètres.

Dans cet exemple de réalisation, la deuxième dimension critique $L_9$, est choisie quant à elle supérieure à la longueur limite Lc prédéterminée.

La deuxième dimension critique $L_9$ peut être par exemple comprise entre une dizaine de fois l'épaisseur de la couche semi-conductrice 103 et plusieurs dizaines de fois l'épaisseur $e_2$ de la couche $102_2$ précontrainte. La deuxième dimension critique $L_9$ peut être par exemple comprise entre 50 et 300 nanomètres et par exemple de l'ordre de 100 nanomètres

Tout au long de la présente description, on appellera « dimension critique » la plus petite dimension réalisée dans une couche mince ou dans un empilement de couches minces, hormis l'épaisseur de cette couche mince ou de cet empilement de couches minces.

La troisième zone $109_1$ et la quatrième zone $109_2$ semi-conductrices sont espacées entre elles d'une distance qui peut être comprise par exemple entre plusieurs nanomètres et plusieurs centaines de nanomètres.

La gravure de la couche 103 peut être réalisée par gravure sélective, par exemple du silicium par rapport au $SiO_2$.

Ensuite (figure 1C), on effectue une gravure de la couche précontrainte $102_2$, perpendiculairement à sa surface. On forme en particulier des tranchées 110, 120, 130, 140, dans la couche isolante 102. Les tranchées 110, 120, 130, 140 sont des tranchées verticales, orthogonales au plan principal du substrat et à celui de la couche précontrainte $102_2$.

En formant ces tranchées 110, 120, 130, 140 on définit des blocs $B_1$, $B_2$, $B_3$. Les tranchées 110, 120, 130, 140, traversent la première couche de matériau diélectrique $102_1$, ainsi qu'au moins une partie de l'épaisseur de la couche précontrainte $102_2$, éventuellement sur toute l'épaisseur de cette couche précontrainte $102_2$.

Les tranchées 110, 120, 130, 140, peuvent être réalisées à l'aide d'une ou plusieurs étapes de gravures anisotropes. Dans cet exemple de réalisation, des tranchées 110, 120, 130, 140, sont formées de part et d'autre de chacune des zones semi-conductrices $108_1$ et $108_2$ de dimension critique $L_8$. Les tranchées 110, 120, 130, 140, sont en particulier réalisées dans le prolongement de flancs des zones semi-conductrices $108_1$ et $108_2$ ayant la première dimension critique $L_8$.

La formation des tranchées permet de relaxer 110, 120, 130, 140, la couche précontrainte $102_2$ au niveau de

sa surface supérieure.

Sur le dispositif de la figure 1C, une première tranchée 110 est réalisée dans le prolongement d'un premier flanc de la première zone $108_1$ semi-conductrice, une deuxième tranchée 120 est quant à elle réalisée dans le prolongement d'un deuxième flanc de la première zone $108_1$ semi-conductrice, opposé au premier flanc. Un premier bloc $B_1$ recouvert de la première zone $108_1$ semi-conductrice est ainsi formé dans les couches de matériau diélectrique $102_2$, $102_3$.

La dimension critique $L_8$ des zones semi-conductrices $108_1$, $108_2$ est prévue au moins inférieure à la profondeur des tranchées 110, 120, 130, 140. Une troisième tranchée 130 est réalisée dans le prolongement d'un premier flanc de la quatrième zone $108_2$ semi-conductrice, une quatrième tranchée 140 étant réalisée dans le prolongement d'un deuxième flanc de la deuxième zone $108_2$ semi-conductrice.

Un deuxième bloc $B_2$ recouvert des zones semi-conductrices $109_1$, $109_2$ ainsi qu'un troisième bloc $B_3$ recouvert de la zone semi-conductrice $108_2$ sont ainsi formés dans les couches de matériau diélectrique $102_2$, $102_3$.

Le premier bloc $B_1$ et le troisième bloc $B_3$ ont des dimensions critiques D1 et D3 égales ou sensiblement égales à la dimension critique $L_8$ des zones semi-conductrices $108_1$ et $108_2$, et inférieures à la profondeur des tranchées.

Le deuxième bloc $B_2$ peut quant à lui être prévu avec une dimension critique supérieure à la profondeur des tranchées, par exemple une dimension critique D2 de l'ordre de 300 nanomètres. Une dimension D2 de l'ordre du double de l'épaisseur de la couche précontrainte permet d'obtenir un bon niveau de compression dans les zones semi-conductrices $109_1$, $109_2$.

La dimension D2 peut quant à elle être prévue au moins supérieure à la profondeur des tranchées 110, 120, 130, 140.

Un transfert sur les zones semi-conductrices $108_1$, $108_2$, de la contrainte de la couche $102_2$ est réalisé. Une gravure effectuée dans toute l'épaisseur de la couche précontrainte $102_2$ permet un transfert plus important de l'état de contrainte sur les zones $108_1$ et $108_2$.

Du fait du choix de la dimension critique $L_8$ ($L_8$ choisie inférieure à une longueur limite Lc prédéterminée) des zones semi-conductrices $108_1$ et $108_2$, et de l'agencement des tranchées 110, 120, 130, 140 par rapport à ces zones semi-conductrices $108_1$ et $108_2$, le type de contrainte exercé sur ces zones semi-conductrices $108_1$ et $108_2$, est identique à celui de la couche précontrainte $102_2$.

Autrement dit, la déformation des zones semi-conductrices $108_1$ et $108_2$ est de même signe que celle de la couche précontrainte $102_2$. Par exemple, dans un cas où la contrainte de la couche précontrainte $102_2$ est une contrainte en tension, une contrainte en tension est également exercée sur les zones semi-conductrices $108_1$ et $108_2$.

Lorsque l'on fait référence à une contrainte exercée sur une zone semi-conductrice $108_1$ ou $108_2$, on entend une contrainte moyenne résultante de l'ensemble des contraintes exercées sur cette zone semi-conductrice $108_1$ ou $108_2$.

Un tel transfert de contrainte sur les zones semi-conductrices $108_1$ et $108_2$, est dû à des effets de bord, qui apparaissent lorsque les zones semi-conductrices sont formées avec une dimension critique suffisamment faible, choisie inférieure à une longueur limite Lc prédéterminée. Cette longueur limite Lc est déterminée en fonction notamment de l'épaisseur de la couche semi-conductrice 103 et des couches sous-jacentes dans lesquelles les tranchées sont réalisées, en particulier de l'épaisseur de la couche isolante $102_3$ et de la couche précontrainte $102_2$.

Le type de contrainte exercé sur les zones semi-conductrices $109_1$ et $109_2$ est différent de celui de la couche précontrainte $102_2$. Autrement dit, la déformation des zones semi-conductrices $108_1$ et $108_2$ est de signe opposé à celle de la couche précontrainte $102_2$. Par exemple, dans un cas où la contrainte de la couche précontrainte $102_2$ est une contrainte en tension, une contrainte en compression est exercée sur les zones semi-conductrices $109_1$ et $109_2$.

Lorsque l'on fait référence à une contrainte exercée sur une zone semi-conductrice $109_1$ ou $109_2$, on entend une contrainte moyenne résultante de l'ensemble des contraintes exercées sur cette zone semi-conductrice $109_1$ ou $109_2$.

Ainsi, un transfert de contrainte différent est exercé sur les zones semi-conductrices $109_1$ et $109_2$.

Ainsi, les tranchées 110, 120, 130, 140 permettent de relaxer la contrainte de la deuxième couche de matériau diélectrique $102_2$ au niveau des blocs $B_1$ - $B_3$, et de transférer cette contrainte en tension au sommet des blocs $B_1$ et $B_3$, c'est-à-dire au niveau des zones semi-conductrices $108_1$, $108_2$.

Dans cet exemple, avec une couche précontrainte $102_2$ en tension, les zones semi-conductrices $108_1$ et $108_2$ subissent une contrainte en tension, tandis que les zones semi-conductrices $109_1$ et $109_2$ subissent quant à elles une contrainte en compression.

La première zone semi-conductrice $108_1$ peut être contrainte en tension et subir une contrainte par exemple de l'ordre d'une centaine de MPa. La zone semi-conductrice $109_1$ peut être contrainte en compression et subir une contrainte par exemple de l'ordre de plusieurs centaines de MPa.

Un espace d'au moins une valeur d prédéterminée, peut être éventuellement prévu entre l'embouchure des tranchées 120, 130, et les zones semi-conductrices $109_1$, $109_2$, afin d'éviter les effets de bord évoqués plus haut sur les zones semi-conductrices $109_1$, $109_2$. Dans cet exemple, les zones semi-conductrices $109_1$ et $109_2$ ayant une dimension critique $L_9$ choisie supérieure à Lc, cet espace d peut être facultatif et peut être faible ou nul.

On peut prévoir et moduler la profondeur des tranchées 110, 120, 130, 140 en fonction du niveau de contrainte que l'on souhaite conférer aux zones semi-conductrices $108_1$, $108_2$, $109_1$, $109_2$.

Les tranchées 110, 120, 130, 140 peuvent être ensuite comblées, par exemple à l'aide d'un matériau isolant 145. Le matériau isolant 145 de remplissage des tranchées peut éventuellement lui-même présenter un état de contrainte.

Puis, on peut former, sur chacune des zones semi-conductrices $108_1$, $108_2$, $109_1$, $109_2$, une zone de diélectrique 160 de grille, et une grille 162 sur la zone de diélectrique 160.

Des espaceurs 163, 164 sur les flancs de la grille 160 peuvent être ensuite réalisés.

Puis, une ou plusieurs étapes de dopage par diffusion et/ou implantation, peuvent être effectuées afin de compléter la formation de zones de source 171 et de drain 172.

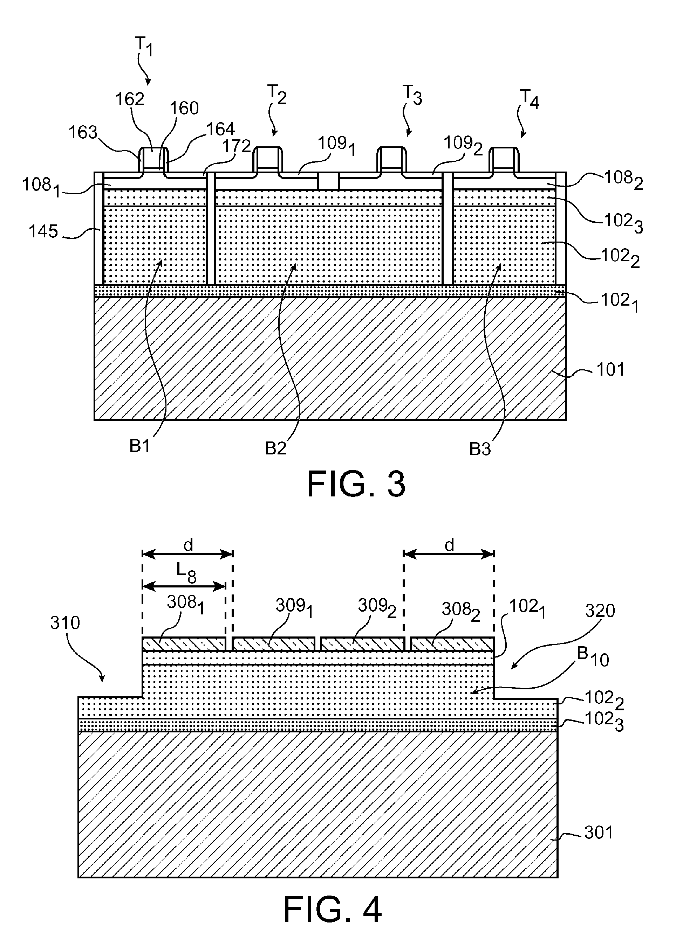

Un dispositif comportant des transistors $T_1$ et $T_4$ dotés de zones de canal formées respectivement dans des zones semi-conductrices $108_1$, $108_2$ contraintes en tension, a ainsi été réalisé et de transistors $T_2$ et $T_3$, comportant des zones de canal respectivement dans des zones semi-conductrices $109_1$, $109_2$ contraintes en compression, a ainsi été réalisé (figure 3).

L'état de contrainte des chacune des zones semi-conductrices $108_1$, $108_2$, $109_1$, $109_2$, obtenues après les différentes étapes décrites ci-dessus, peut être estimé à l'aide de calculs numériques effectués avec un outil de simulation, par exemple tel que l'outil ANSYS-v10 de la société ANSYS.

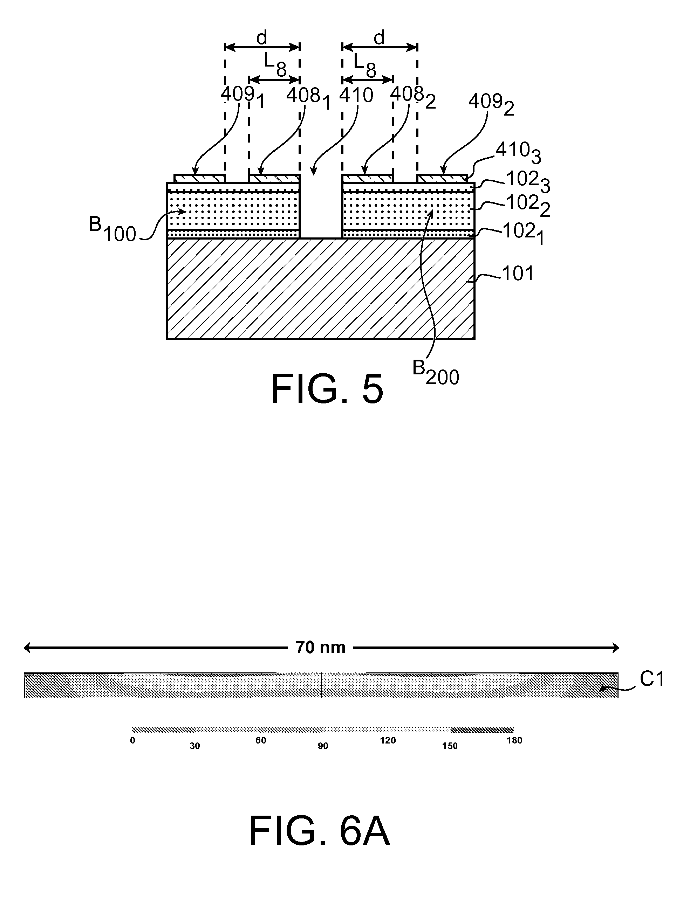

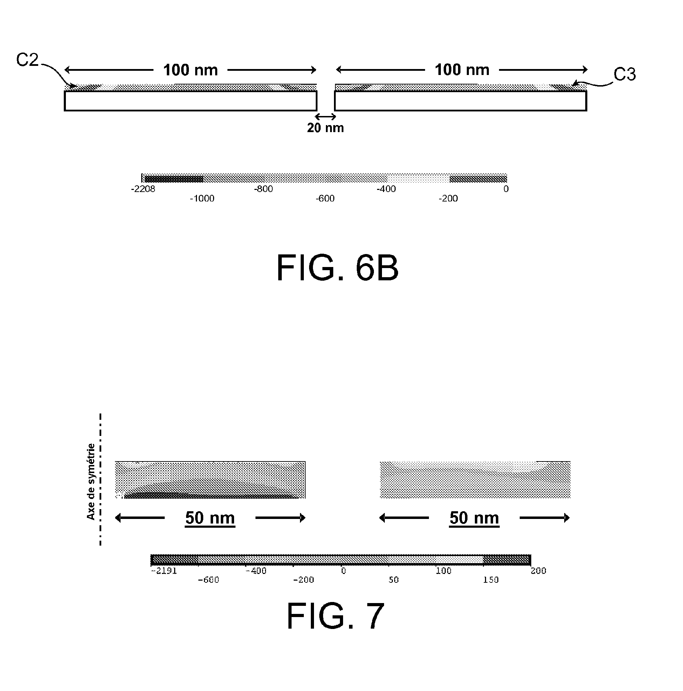

Sur les figures 6A et 6B des champs de contraintes selon l'axe $[O;\vec{i}]$ de la direction du transport, sont donnés. La figure 6A montre, par l'intermédiaire du champ de contraintes C1, que dans une épaisseur donnée de leur face supérieure, par exemple de l'ordre de 3 à 4 nanomètres, les zones semi-conductrices $108_1$, $108_2$ ont une contrainte globale moyenne positive et sont ainsi contraintes en tension.

Sur la figure 6B, les champs de contraintes $C_2$ et $C_3$, montrent que dans une épaisseur donnée de leur face supérieure, par exemple de l'ordre de 3 à 4 nanomètres, les zones semi-conductrices $109_1$, $109_2$ ont une contrainte globale moyenne négative et sont ainsi contraintes en compression.

Selon une variante (figure 2) de réalisation du procédé, on effectue des tranchées 210, 220, 230, 240 verticales, orthogonales au plan principal du substrat de la couche précontrainte $102_2$, traversant la troisième couche de matériau diélectrique $102_3$ ainsi que toute l'épaisseur de la couche $102_2$ précontrainte, de manière à dévoiler la première couche de matériau diélectrique $102_1$. Cela permet d'obtenir un état de contrainte plus important sur les zones semi-conductrices.

Selon une autre possibilité de réalisation, la couche semi-conductrice 103 reposant sur la couche isolante 102 peut être également une couche précontrainte, c'est-à-dire ayant une contrainte intrinsèque. La couche semi-conductrice 103 peut par exemple posséder une contrainte bi-axiale dans un plan perpendiculaire au plan principal du substrat. La pré-déformation de la couche semi-conductrice 103 peut dans ce cas, avoir été obtenue par exemple par hétéroépitaxie ou par collage moléculaire.

Deux exemples de méthodes, pour définir la longueur limite Lc, vont être donnés. Une combinaison des 2 méthodes peut être éventuellement utilisée.

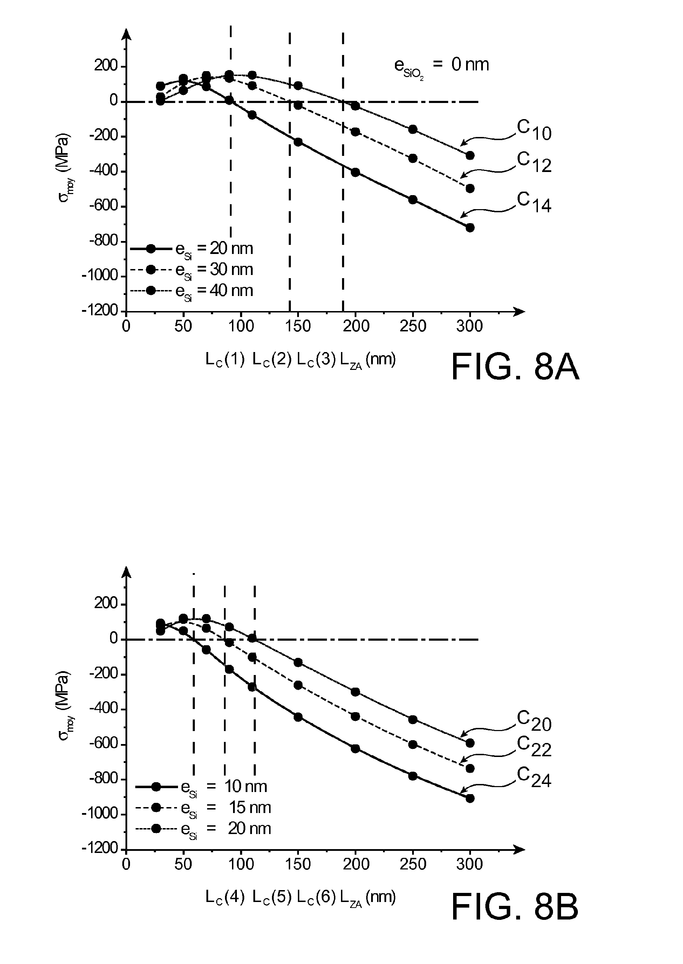

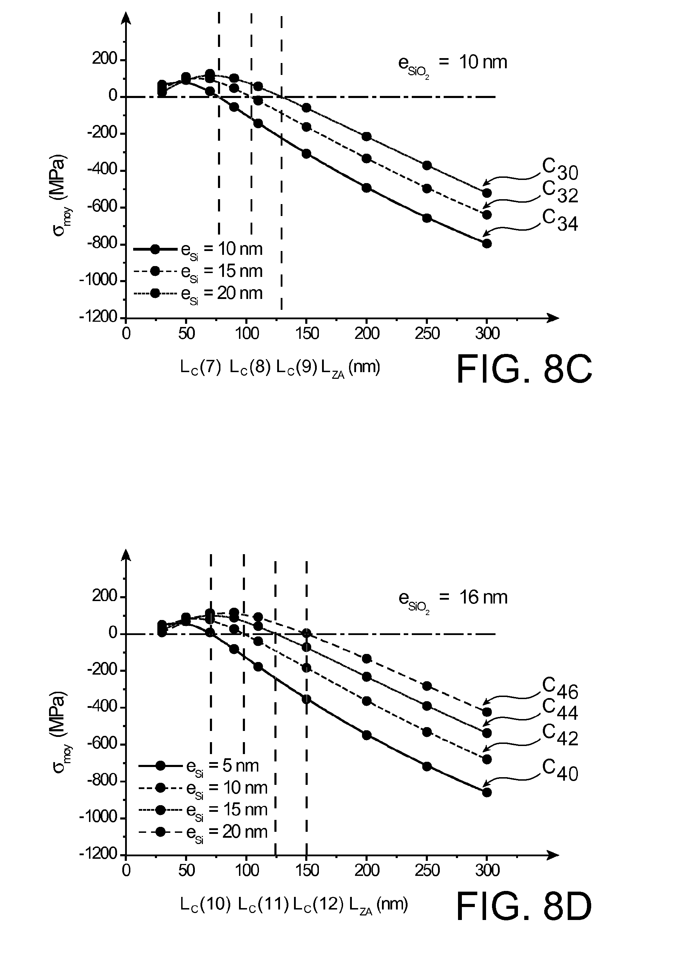

Sur les figures 8A-8D, différents résultats de simulations sont illustrés, et sont représentatifs de l'état de contrainte moyenne $\sigma_{moy}$ sur une épaisseur de l'ordre de 3 nm d'une zone semi-conductrice 508 ayant un agencement semblable à celui la zone $108_1$ du dispositif décrit précédemment en liaison avec la figure 2.

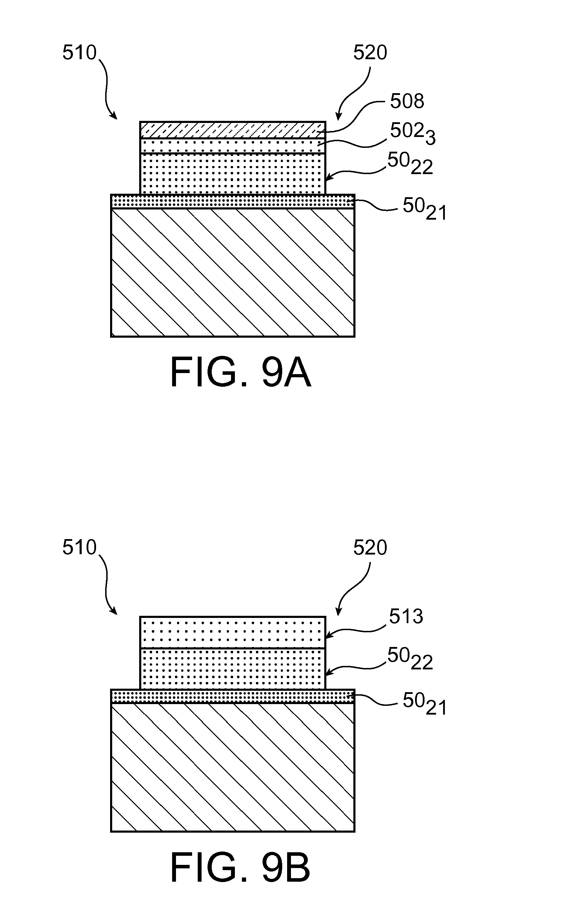

La zone semi-conductrice 508 repose sur une zone isolante 502, par exemple à base de $SiO_2$, elle même reposant sur une zone précontrainte $502_2$, par exemple à base de $Si_3N_4$, elle-même reposant sur une couche isolante $502_1$, par exemple à base de $SiO_2$. Cette zone semi-conductrice 508 est destinée à contenir le canal d'un transistor et correspond à la région dans laquelle un transport de charges s'effectue. Des tranchées 510, 520 sont réalisées de part et d'autre des zones 508, $502_3$, $502_2$, jusqu' à la couche isolante $502_1$ (figure 9A).

Des simulations, ont été effectuées avec l'outil ANSYS pour plusieurs dimensions $L_{ZA}$ de la zone semi-conductrice 508, et pour différentes épaisseurs $e_{Si}$ de cette zone semi-conductrice 508, et différentes épaisseurs et $e_{SiO2}$ de la couche isolante $502_3$ à base de $SiO_2$. Pour ces simulations, l'épaisseur de la couche $502_2$ précontrainte a quant à elle été fixée. Cette épaisseur est prévue grande devant les épaisseurs de la zone semi-conductrice 508 et de la zone $502_1$, pour une couche $502_2$ précontrainte à base de nitrure, d'épaisseur fixée à 200 nm.

Sur la figure 8A, les courbes $C_{10}$, $C_{12}$, $C_{14}$ représentent un état de contrainte moyenne $\sigma_{moy}$ de la zone semi-conductrice 508 en fonction de sa longueur $L_{ZA}$, avec $e_{SiO2} = 0$ nm respectivement, pour $e_{Si} = 20$ nm, $e_{Si} = 30$ nm, $e_{Si} = 40$ nm.

Sur la figure 8B, les courbes $C_{20}$, $C_{22}$, $C_{24}$ représentent un état de contrainte moyenne $\sigma_{moy}$ d'un motif semi-conducteur en fonction de sa longueur $L_{ZA}$, avec $e_{SiO2} = 5$ nm respectivement, pour $e_{Si} = 10$ nm, $e_{Si} = 15$ nm, et $e_{Si} = 20$ nm.

Sur la figure 8C, les courbes $C_{30}$, $C_{32}$, $C_{34}$ représentent un état de contrainte moyenne $\sigma_{moy}$ d'un motif semi-conducteur en fonction de sa longueur $L_{ZA}$, avec $e_{SiO2} = 10$ nm, respectivement, pour $e_{Si} = 10$ nm, $e_{Si} = 15$ nm, et $e_{Si} = 20$ nm.

Sur la figure 8A, les courbes $C_{40}$, $C_{42}$, $C_{44}$, $C_{46}$ représentent un état de contrainte moyenne $\sigma_{moy}$ d'un motif semi-conducteur en fonction de sa longueur $L_{ZA}$, avec $e_{SiO2} = 16$ nm respectivement, pour $e_{Si} = 5$ nm, $e_{Si} = 10$ nm, $e_{Si} = 15$ nm, et $e_{Si} = 20$ nm.

Sur toutes ces figures, la longueur limite Lc, correspond à la valeur limite pour laquelle la contrainte moyenne $\sigma_{moy}$ de la zone semi-conductrice 508 change de signe et passe de la tension à la compression.

Les valeurs limites obtenues pour différentes épaisseurs notées Lc() sont représentées à l'aide de lignes verticales discontinues sur les figures 8A à 8D.

Une première méthode consiste ainsi à, prévoir l'épaisseur et la composition des couches $50_3$, $502_2$, $502_3$ et utiliser de telles simulations pour déterminer Lc. Pour une épaisseur donnée de la couche $502_2$, cette longueur critique Lc augmente avec l'épaisseur de la zone semi-conductrice 508. De même pour une épaisseur donnée de cette zone 508, la longueur limite Lc augmente avec l'épaisseur de la couche isolante $502_3$.

Selon une deuxième méthode, on utilise une relation empirique établie entre la longueur limite Lc, et les différentes dimensions de la structure telles que l'épaisseur de la couche précontrainte $502_2$, de la couche isolante $502_3$, à l'aide d'un modèle analytique tel que celui du document [1] : Hu et al., Appl. Phys., 50(7), p.4661, juillet 1979, et du document [2] : Hu et al., Appl. Phys., 70(6), p.R53, septembre 1991 peut être utilisé.

Cette relation peut être établie en utilisant éventuellement une approximation selon laquelle on considère une zone semi-conductrice 508 d'épaisseur faible devant celle du substrat, dont la contrainte $\sigma_0$ est uniforme dans le plan principal de cette zone et nulle dans la direction de son épaisseur.

Une relation entre le rapport de la contrainte moyenne $\sigma_{moy}$ et de la contrainte $\sigma_0$ : $(\sigma_{moy}/\sigma_0)$, et entre le paramètre réduit (KL/h) peut être utilisée.

$$\text{Avec :} \quad K = \frac{E_{substrat}(1-\nu_{film}^2)}{E_{film}(1-\nu_{substrat}^2)} \quad ;$$

Efilm : le module de Young de la zone semi-conductrice 508 ;
Esubstrat : le module de Young du substrat ;
$\nu$film : le coefficient de Poisson de la zone semi-conductrice 508 ;
$\nu$film : le coefficient de Poisson du substrat ;

Afin de se ramener à un cas similaire à celui du modèle décrit dans les documents [1] et [2], on peut utiliser une autre approximation dans laquelle on remplace le bicouche formé par la couche isolante $502_3$ et la zone semi-conductrice 508 à base de Si par une seule couche 513 de $SiO_2$ d'épaisseur équivalente $e_{eq}$, de sorte que : $e_{eq} = e_{SiO2} + e_{Si\equiv SiO2}$, avec $e_{Si\equiv SiO2}$ représente l'épaisseur équivalente d'un point de vue mécanique en $SiO_2$ de la couche de zone semi-conductrice 508 (figure 9B).

La rigidité en flexion de ces deux couches (($e_{Si\equiv SiO2}$) et ($e_{Si}$)) est de préférence constante.

On obtient la relation suivante :

$$\frac{I_{Si\equiv SiO2} \cdot E_{SiO2}}{1-\nu_{SiO2}^2} = \frac{I_{Si} \cdot E_{Si}}{1-\nu_{Si}^2} \quad \Rightarrow \quad e_{Si\equiv SiO2} = \left(\frac{E_{Si}(1-\nu_{SiO2}^2)}{E_{SiO2}(1-\nu_{Si}^2)}\right)^{1/3} \cdot e_{Si}$$

Avec $I_i$ représente le moment d'inertie de la couche i.

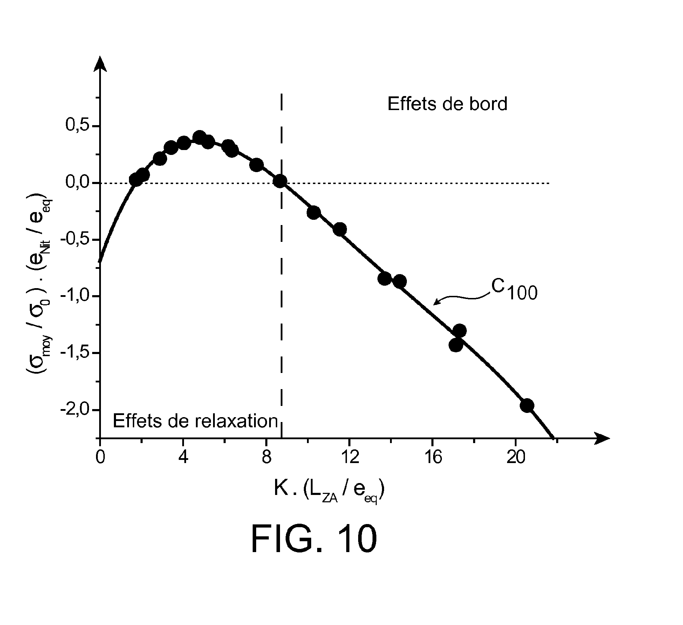

Sur la figure 10, un exemple de courbe d'évolution $C_{100}$ du rapport $(\sigma_{moy}/\sigma_0)$ * $(e_{nit}/e_{eq})$ en fonction de $(K.L_{ZA}/e_{eq})$

est donné, avec : $\quad K = \frac{E_{Nit}(1-\nu_{SiO2}^2)}{E_{SiO2}(1-\nu_{Nit}^2)} \quad$, $e_{nit}$ l'épaisseur de la couche précontrainte $502_2$

Les résultats représentés par cette courbe $C_{100}$ concernent deux exemples de réalisation: un premier dans lequel l'épaisseur $e_{SiO2}$ est de l'ordre de 16 nm avec une épaisseur $e_{Si}$ de l'ordre de 15 nanomètres et un deuxième exemple de réalisation dans lequel une épaisseur d'oxyde $e_{SiO2}$ de l'ordre de 16 nm avec une épaisseur de Silicium $e_{Si}$ de l'ordre de 20 nm.

Dans les deux cas, l'évolution de la contrainte moyenne en fonction du paramètre réduit $(K.L_{ZA}/e_{eq})$ est presque identique et représenté par la courbe $C_{100}$ sur la figure 10, et peut être rapprochée par un ajustement polynomial d'ordre 5.

Cette courbe $C_{100}$ s'annule pour une valeur de :

$$\left( K \cdot L_{ZA} \Big/ e_{eq} \right)_c \approx 8.77$$

On peut ainsi obtenir une valeur de $L_c$ correspondant au point auquel la courbe s'annule, pour n'importe quelle épaisseur de la couche isolante $502_3$ et de la zone semi-conductrice $508$.

Une combinaison des 2 méthodes précitées peut être éventuellement utilisée. On peut extraire des valeurs de longueur limite $L_c$ pour différents couples ($e_{SiO2}$ ; $e_{Si}$), en extrapolant les courbes telles qu'illustrées sur les figures 8A-8B, puis en peut comparer ces valeurs avec celles calculées à l'aide de la formule empirique donnée plus haut.

Des résultats de cette comparaison sont donnés par exemple dans le tableau ci-dessous.

| ($e_{sio2}$ ; $e_{si}$) (nm) | ($L_{za}$)$_c$ (nm) | ($L_{za}$)$_c$ calculée (nm) |
|---|---|---|
| (0 ; 40) | 192 | 189 |
| (0 ; 20) | 95 | 92 |
| (5 ; 20) | 113 | 112 |
| (5 ; 10) | 65 | 60 |
| (10 ; 20) | 131 | 131 |
| (10 ; 10) | 83 | 79 |
| (16 ; 10) | 104 | 100 |

Les valeurs la longueur limite $L_C$ obtenues par les deux exemples de méthodes précités sont très proches l'une de l'autre.

La figure 4 illustre une variante de l'exemple de dispositif microélectronique décrit précédemment en liaison avec la figure 2. Dans cet exemple, le dispositif comprend des zones semi-conductrices $308_1$, $308_2$, $309_1$, $309_2$, destinées à former des zones actives réparties sur un même bloc isolant $B_{10}$.

Une première zone semi-conductrice $308_1$, et une deuxième zone semi-conductrice $308_2$, ont une dimension critique $L_8$ prévue inférieure à la longueur limite Lc divisée par 2 prédéterminée, dont des méthodes de détermination ont été données plus haut, et qui est déterminée en fonction notamment de l'épaisseur des zones semi-conductrices des couches $102_3$ et $102_2$.

Une troisième zone semi-conductrice $309_1$, et une quatrième zone semi-conductrice $309_2$, ont une dimension critique qui peut être également inférieure ou égale à la longueur limite Lc prédéterminée.

Les zones semi-conductrices $308_1$, $309_1$, $308_2$, $309_2$, sont contraintes et reposent sur un bloc $B_{10}$ gravé formé dans un empilement de couches minces comportant une couche précontrainte $102_2$. Des tranchées 310, 320, sont réalisées dans une partie de l'épaisseur de la couche précontrainte $102_2$, de part et d'autre du bloc $B_{10}$ gravé. Les tranchées 310, 320, ont une profondeur supérieure à la dimension critique $L_8$ des zones semi-conductrice $308_1$ et $308_2$. Une tranchée 320 est réalisée dans le prolongement d'un flanc de la zone semi-conductrice $308_2$. Une autre tranchée 310 est quant à elle réalisée dans le prolongement d'un flanc de la zone semi-conductrice $308_1$. Un transfert de la contrainte de la couche précontrainte $102_2$ au sommet du bloc $B_{10}$ est mis en oeuvre dans les zones semi-conductrices $308_1$ et $308_2$.

Dans un cas par exemple où la couche précontrainte $102_2$ est contrainte en tension, les zones semi-conductrices $308_1$ et $308_2$ sont également contraintes en tension.

Une zone semi-conductrice $309_2$ juxtaposée à la zone semi-conductrice $308_2$, est quant à elle située à une distance d d'au moins Lc/2 de la tranchée 320.

Avec un tel agencement, dans un cas par exemple où la couche précontrainte $102_2$ est contrainte en tension, les zones semi-conductrices $109_1$ et $109_2$ sont contraintes en compression ou ont une contrainte moyenne correspondant à une contrainte en compression.

Sur la figure 5, un autre exemple de dispositif microélectronique obtenu à l'aide d'un procédé suivant l'invention est donné.

Le dispositif comprend des zones semi-conductrices $408_1$, $408_2$ contraintes selon un premier type de contrainte, par exemple une contrainte en tension, et des zones semi-conductrices $409_1$, $409_2$ contraintes selon un deuxième type de contrainte, par exemple une contrainte en compression.

Les zones semi-conductrices $408_1$, $409_1$, peuvent avoir été formées à partir d'une couche semi-conductrice pré-contrainte, et reposent sur un premier bloc $B_{100}$ formé d'un empilement de couches de matériau diélectrique $102_1$,

$102_2$, $102_3$ dont au moins une couche $102_2$ précontrainte, par exemple en tension.

Les zones semi-conductrices $408_2$, $409_2$ peuvent avoir été formées à partir de ladite couche semi-conductrice pré-contrainte, et reposent sur un deuxième bloc $B_{200}$ formé dans l'empilement de couches de matériau diélectrique $102_1$, $102_2$, $102_3$.

Les zones semi-conductrices $408_1$, $408_2$ sont prévus avec une dimension critique $L_8 < Lc/2$, avec Lc la longueur limite dont des méthodes de détermination ont été données plus haut, et qui est fonction de l'épaisseur des zones semi-conductrices ainsi que de l'épaisseur respective des couches $102_2$ et $102_3$.

Une tranchée 410 sépare le premier bloc $B_{100}$ du deuxième bloc $B_{200}$. Cette tranchée est réalisée dans le prolongement d'un flanc de la zone semi-conductrice $408_1$ et d'un flanc de la zone semi-conductrice $408_2$. Les zones semi-conductrices $409_1$ et $409_2$ sont quant à elles situées à une distance d'au moins Lc/2 de la tranchée 410, afin de permettre de conférer à ces zones semi-conductrices $409_1$ et $409_2$, une contrainte de signe opposée à celle de la contrainte de la couche précontrainte et de la contrainte des zones semi-conductrices $408_1$, $408_2$.

Sur la figure 7 des champs de contraintes selon l'axe $[O; \vec{l})$ de la direction du transport, sont donnés. Cette figure montre, par l'intermédiaire du champ de contraintes C3, que la zone semi-conductrice $408_2$ est contrainte en tension, tandis que le champ de contraintes C4, montre que la zone semi-conductrice $409_2$ est contrainte en compression.

## Revendications

1. Procédé de réalisation d'un dispositif microélectronique comportant, sur un même support : au moins une zone semi-conductrice contrainte en tension, et au moins une zone semi-conductrice contrainte en compression, le procédé comportant les étapes consistant à :

   a) réaliser, à partir d'un empilement de couches reposant sur un substrat et comportant au moins une couche semi-conductrice (103) située au-dessus d'au moins une couche précontrainte ($102_2$): au moins une première zone semi-conductrice ($108_1$) ayant une première dimension critique $L_8$ prévue inférieure à une longueur limite Lc, et au moins une deuxième zone semi-conductrice ($109_1$) ayant une deuxième dimension critique $L_9$ prévue supérieure à ladite longueur limite Lc, la première zone semi-conductrice et la deuxième zone semi-conductrice étant formées à partir de la couche semi-conductrice et étant disjointes, la première dimension critique et la deuxième dimension critique correspondant respectivement à la plus petite dimension de la première zone semi-conductrice hormis son épaisseur et à la plus petite dimension de la deuxième zone semi-conductrice hormis son épaisseur,

   b) réalisation d'une ou plusieurs tranchées (110, 120, 130, 140, 210, 220, 230, 240) dans au moins une partie de l'épaisseur de ladite couche précontrainte, au moins une tranchée (110) parmi lesdites tranchées étant située dans le prolongement d'au moins un flanc de ladite première zone semi-conductrice ($108_1$) au moins une autre tranchée (120) étant réalisée dans le prolongement d'un autre flanc de ladite première zone semi-conductrice ($108_1$), opposé audit flanc, la longueur limite Lc correspondant à une valeur limite pour laquelle la contrainte moyenne d'une zone semi-conductrice (508) donnée issue de ladite couche semi-conductrice change de signe et passe d'un état de tension à un état de compression, quand cette zone semi-conductrice (508) donnée est dotée d'un premier flanc dans le prolongement d'une première desdites tranchées et d'un deuxième flanc dans le prolongement d'une deuxième desdites tranchées, la longueur limite Lc ayant été déterminée en fonction de l'épaisseur des couches de l'empilement dans lesquelles les tranchées sont réalisées, le procédé étant tel que la première zone semi-conductrice a, suite à l'étape b) , une contrainte du même type que ladite couche précontrainte, ladite deuxième zone semi-conductrice ayant une contrainte d'un type opposé à celui de ladite couche précontrainte.

2. Procédé de réalisation d'un dispositif microélectronique comportant, sur un même support : au moins une zone semi-conductrice contrainte en tension, et au moins une zone semi-conductrice contrainte en compression, le procédé comportant les étapes consistant à :

   a) réaliser à partir d'un empilement de couches reposant sur un substrat et comportant au moins une couche semi-conductrice (103) situé au-dessus d'au moins une couche précontrainte ($102_2$), au moins une première zone semi-conductrice ($308_1$, $408_1$) ayant une première dimension critique $L_8$ prévue inférieure à une longueur égale à une longueur limite L divisée par 2 et au moins une deuxième zone semiconductrice ($309_1$, $409_1$), la première zone semi-conductrice et la deuxième zone semi-conductrice étant formées à partir de ladite couche semi-conductrice et étant disjointes, la première dimension critique correspondant à la plus petite dimension de la première zone semi-conductrice hormis son épaisseur

b) réalisation d'une ou plusieurs tranchées (310, 350) dans au moins une partie de l'épaisseur de ladite couche précontrainte, au moins une première tranchée (310) parmi lesdites tranchées étant située dans le prolongement d'au moins un flanc de ladite première zone semi-conductrice ($308_1$), un espace d, tel que d > Lc/2, est prévu entre ladite deuxième zone semi-conductrice ($309_1$) et chacune des tranchées, la longueur limite Lc correspondant à une valeur limite pour laquelle la contrainte moyenne d'une zone semi-conductrice donnée issue de ladite couche semi-conductrice (508) change de signe et passe d'un état de tension à un état de compression, quand cette zone semi-conductrice donnée (508) est dotée d'un premier flanc dans le prolongement d'une première desdites tranchés et d'un deuxième flanc dans le prolongement d'une deuxième desdites tranchés cette longueur limite Lc ayant été déterminée en fonction de l'épaisseur des couches de l'empilement dans lesquelles les tranchées sont réalisées, le procédé étant tel que la première zone semi-conductrice a, suite à l'étape b), une contrainte du même type que ladite couche précontrainte, ladite deuxième zone semi-conductrice ayant une contrainte d'un type opposé à celui de ladite couche précontrainte.

3. Procédé selon la revendication 2, ladite deuxième zone semi-conductrice ayant une dimension critique $L_9$ inférieure ou égale à la première dimension critique $L_8$.

4. Procédé selon l'une des revendications 2 ou 3, parmi lesdites tranchées au moins une autre tranchée étant réalisée dans le prolongement d'un deuxième flanc de ladite première zone semi-conductrice, opposé audit premier flanc.

5. Procédé selon l'une des revendications 1 à 4, dans lequel la deuxième zone semi-conductrire ($109_1$, $309_1$, $409_1$) repose sur un bloc gravé (B2, B10, B200) à l'étape b) dans ledit empilement, avec au moins deux des dites tranchées situées de part et d'autre dudit bloc gravé.

6. Procédé selon la revendication 5, ledit bloc gravé (B2, B10, B200) ayant une dimension (D2) critique supérieure à la profondeur des dites tranchées.

7. Procédé selon l'une des revendications 1 à 6, ladite couche précontrainte ($102_2$) étant à base d'un matériau diélectrique tel que du $Si_3N_4$.

8. Procédé selon l'une des revendications 1 à 7, ledit empilement comprenant une couche d'adhérence ($102_3$) entre la couche précontrainte ($102_2$) et la couche semi-conductrice (103).

9. Procédé selon l'une des revendications 1 à 8, ladite couche ($102_2$) précontrainte étant située sur une couche de matériau diélectrique ($102_1$) reposant sur une couche (101) de support semi-conductrice.

10. Procédé selon l'une des revendications 1 à 9, comprenant en outre : le remplissage des tranchées à l'aide d'un matériau isolant (145).

11. Procédé selon l'une des revendications 1 à 10, comprenant en outre : la formation sur une ou plusieurs ou sur l'ensemble des dites zones semi-conductrices d'au moins une zone de diélectrique de grille et d'au moins une grille sur la zone de diélectrique de grille.

12. Procédé selon l'une des revendications 1 à 11, dans lequel la couche précontrainte est contrainte en tension, la première zone semi-conductrice étant contrainte en tension, la deuxième zone semi-conductrice étant contrainte en compression.

13. Procédé selon l'une des revendications 1 à 12, la profondeur des tranchées étant égale à la moitié de la dimension critique $L_8$ de ladite première zone semi-conductrice.

**Patentansprüche**

1. Verfahren zur Herstellung einer mikroelektronischen Vorrichtung, umfassend auf ein und demselben Träger: wenigstens eine zuggespannte Halbleiterzone und wenigstens eine druckgespannte Halbleiterzone, wobei das Verfahren die folgenden Schritte umfasst:

a) herstellen, ausgehend von einem Stapel von Schichten, die auf einem Substrat ruhen und wenigstens eine Halbleiterschicht (103) umfassen, die über wenigstens einer vorgespannten Schicht ($102_2$) liegt: wenigstens

eine erste Halbleiterzone ($108_1$) mit einer ersten kritischen Abmessung $L_8$, die kleiner als eine Grenzlänge Lc vorgesehen ist, und wenigstens eine zweite Halbleiterzone ($109_1$) mit einer zweiten kritischen Abmessung $L_9$, die größer als die Grenzlänge Lc vorgesehen ist, wobei die erste Halbleiterzone und die zweite Halbleiterzone ausgehend von der Halbleiterschicht gebildet werden und getrennt sind, wobei die erste kritische Abmessung und die zweite kritische Abmessung der kleinsten Abmessung der ersten Halbleiterzone abgesehen von ihrer Dicke bzw. der kleinsten Abmessung der zweiten Halbleiterzone abgesehen von ihrer Dicke entsprechen,

b) herstellen eines oder mehrerer Gräben (110, 120, 130, 140, 210, 220, 230, 240) in wenigstens einem Teil der Dicke der vorgespannten Schicht, wobei wenigstens ein Graben (110) von den Gräben in der Verlängerung wenigstens einer Flanke der ersten Halbleiterzone ($108_1$) liegt, wobei wenigstens ein anderer Graben (120) in der Verlängerung einer anderen Flanke der ersten Halbleiterzone ($108_1$) hergestellt wird, die der Flanke entgegengesetzt ist, wobei die Grenzlänge Lc einem Grenzwert entspricht, für den die mittlere Spannung einer gegebenen Halbleiterzone (508), die aus der Halbleiterschicht hervorgegangen ist, ihr Vorzeichen wechselt und von einem Zug-Zustand in einen Druck-Zustand übergeht, wenn diese gegebene Halbleiterzone (508) ausgestattet ist mit einer ersten Flanke in der Verlängerung eines ersten der Gräben und mit einer zweiten Flanke in der Verlängerung eines zweiten der Gräben, wobei die Grenzlänge Lc als Funktion der Dicke der Schichten des Stapels bestimmt worden ist, in denen die Gräben hergestellt sind,

wobei das Verfahren derart ist, dass die erste Halbleiterzone im Anschluss an den Schritt b) eine Spannung vom gleichen Typ hat wie die vorgespannte Schicht, wobei die zweite Halbleiterzone eine Spannung von einem Typ entgegengesetzt zu jenem der vorgespannten Schicht hat.

2. Verfahren zur Herstellung einer mikroelektronischen Vorrichtung, umfassend auf ein und demselben Träger: wenigstens eine zuggespannte Halbleiterzone und wenigstens eine druckgespannte Halbleiterzone, wobei das Verfahren die folgenden Schritte umfasst:

a) herstellen, ausgehend von einem Stapel von Schichten, die auf einem Substrat ruhen und wenigstens eine Halbleiterschicht (103) umfassen, die über wenigstens einer vorgespannten Schicht ($102_2$) liegt, wenigstens einer ersten Halbleiterzone ($308_1$, $408_1$) mit einer ersten kritischen Abmessung $L_8$, die kleiner vorgesehen ist als eine Länge gleich einer Grenzlänge Lc geteilt durch 2, und wenigstens einer zweiten Halbleiterzone ($309_1$, $409_1$), wobei die erste Halbleiterzone und die zweite Halbleiterzone ausgehend von der Halbleiterschicht gebildet werden und getrennt sind, wobei die erste kritische Abmessung der kleinsten Abmessung der ersten Halbleiterzone abgesehen von ihrer Dicke entspricht,

b) herstellen eines oder mehrerer Gräben (310, 350) in wenigstens einem Teil der Dicke der vorgespannten Schicht, wobei wenigstens ein erster Graben (310) von den Gräben in der Verlängerung wenigstens einer Flanke der ersten Halbleiterzone ($308_1$) liegt, wobei ein Abstand d mit d > Lc/2 zwischen der zweiten Halbleiterzone ($309_1$) und jedem der Gräben vorgesehen ist, wobei die Grenzlänge Lc einem Grenzwert entspricht, für den die mittlere Spannung einer gegebenen Halbleiterzone, die aus der Halbleiterschicht (508) hervorgegangen ist, ihr Vorzeichen wechselt und von einem Zug-Zustand in einen Druck-Zustand übergeht, wenn diese gegebene Halbleiterzone (508) ausgestattet ist mit einer ersten Flanke in der Verlängerung eines ersten der Gräben und mit einer zweiten Flanke in der Verlängerung eines zweiten der Gräben, wobei diese Grenzlänge Lc als Funktion der Dicke der Schichten des Stapels bestimmt worden ist, in denen die Gräben hergestellt sind,

wobei das Verfahren derart ist, dass die erste Halbleiterzone im Anschluss an den Schritt b) eine Spannung vom gleichen Typ hat wie die vorgespannte Schicht, wobei die zweite Halbleiterzone eine Spannung von einem Typ entgegengesetzt zu jenem der vorgespannten Schicht hat.

3. Verfahren nach Anspruch 2, wobei die zweite Halbleiterzone eine kritische Abmessung $L_9$ kleiner oder gleich der ersten kritischen Abmessung $L_8$ hat.

4. Verfahren nach einem der Ansprüche 2 oder 3, wobei von den Gräben wenigstens ein weiterer Graben in der Verlängerung einer zweiten Flanke der ersten Halbleiterzone hergestellt wird, die zu der ersten Flanke entgegengesetzt ist.

5. Verfahren nach einem der Ansprüche 1 bis 4, bei dem die zweite Halbleiterzone ($109_1$, $309_1$, $409_1$) auf einem im Schritt b) in dem Stapel gravierten Block (B2, B10, B200) ruht, wobei wenigstens zwei der Gräben auf beiden Seiten des gravierten Blocks angeordnet sind.

6. Verfahren nach Anspruch 5, wobei der gravierte Block (B2, B10, B200) eine kritische Abmessung (D2) größer als die Tiefe der Gräben hat.

**7.** Verfahren nach einem der Ansprüche 1 bis 6, wobei die vorgespannte Schicht ($102_2$) auf Basis eines dielektrischen Materials ist, beispielsweise $Si_3N_4$.

**8.** Verfahren nach einem der Ansprüche 1 bis 7, wobei der Stapel eine Anhaftschicht ($102_3$) zwischen der vorgespannten Schicht ($102_2$) und der Halbleiterschicht (103) umfasst.

**9.** Verfahren nach einem der Ansprüche 1 bis 8, wobei die vorgespannte Schicht ($102_2$) auf einer Schicht aus dielektrischem Material ($102_1$) angeordnet ist, die auf einer halbleitenden Trägerschicht (101) ruht.

**10.** Verfahren nach einem der Ansprüche 1 bis 9, ferner umfassend: das Füllen der Gräben mit Hilfe eines isolierenden Materials (145).

**11.** Verfahren nach einem der Ansprüche 1 bis 10, ferner umfassend: das Bilden wenigstens einer Gitterdielektrizitätszone und wenigstens eines Gitters auf der Gitterdielektrizitätszone auf einer oder mehreren oder auf der Gesamtheit der Halbleiterzonen.

**12.** Verfahren nach einem der Ansprüche 1 bis 11, bei dem die vorgespannte Schicht zuggespannt ist, wobei die erste Halbleiterzone zuggespannt ist und die zweite Halbleiterzone druckgespannt ist.

**13.** Verfahren nach einem der Ansprüche 1 bis 12, wobei die Tiefe der Gräben gleich der Hälfte der kritischen Abmessung $L_8$ der ersten Halbleiterzone ist.

**Claims**

**1.** Method of forming a microelectronic device comprising, on a same support: at least one tensile strained semi-conductor zone, and at least one compressive strained semi-conductor zone, the method comprising the steps consisting in:

a) forming from a stack of layers resting on a substrate and comprising at least one semi-conductor layer (103) situated above at least one prestrained layer ($102_2$): at least one first semi-conductor ($108_1$) zone having a first critical dimension $L_8$ provided less than a predetermined limit length Lc, and at least one second semi-conductor zone having a second critical dimension $L_9$ provided greater than said predetermined limit length Lc, the first semi-conductor zone and the second semi-conductor zone being formed from the semi-conductor layer and being disjoined, the first critical dimension and the second critical dimension corresponding respectively to the smallest dimension of the first semi-conductor zone except its thickness and to the smallest dimension of the second semi-conductor zone except its thickness,
b) forming one or several trenches (110, 120, 130, 140, 210, 220, 230, 240) in at least a part of the thickness of said pre-strained layer, at least one trench (110) among said trenches being situated in the continuation of at least one first side of said first semi-conductor zone ($108_1$), at least another trench (120) among said trenches being situated in the continuation of at least another side of said first semi-conductor zone ($108_1$), opposed to said side, the the limit length Lc corresponding to a limit value for which the mean strain of a given semi-conductor zone (508) of said semi-conductor layer change sign from a tensile state to a compressive state and when this given zone (508) has a first side in the continuation of a first trench of said trenches and when this given zone (508) has a second side in the continuation of a second trench of said trenches, the limit length Lc having been determined as a function of the thickness of the layers of the stack in which the trenches are made, the method being such that first semi-conductor zone has, after step b), a strain of the same type as said pre-strained layer, said second semi-conductor zone having a strain of a type opposite to that of said pre-strained layer.

**2.** Method of forming a microelectronic device comprising, on a same support: at least one tensile strained semi-conductor zone, and at least one compressive strained semi-conductor zone, the method comprising the steps consisting in:

a) forming from a stack of layers resting on a substrate and comprising at least one semi-conductor layer (103) situated above at least one prestrained layer ($102_2$): at least one first semi-conductor ($308_1$, $408_1$) zone having a first critical dimension $L_8$ provided less than a limit length Lc divided by two and at least one second semi-conductor zone ($309_1$, $409_1$), said first semi-conductor zone and said second semi-conductor zone being formed from said semi-conductor layer and being disjoined, the first critical dimension corresponding to the smallest dimension of the first semi-conductor zone except its thickness,

b) forming one or several trenches (310, 350) in at least a part of the thickness of said pre-strained layer, at least one trench (310) among said trenches being situated in the continuation of at least one first side of said first semi-conductor zone ($308_1$), a space d, such that d > Lc/2 being provided between said second semi-conductor zone ($309_1$) and each of said trenches, the limit length Lc corresponding to a limit value for which the mean strain of a given semi-conductor zone (508) of said semi-conductor layer change sign from a tensile state to a compressive state when this given zone (508) has a first side in the continuation of a first trench of said trenches and when this given zone (508) has a second side in the continuation of a second trench of said trenches, the limit length Lc having been determined as a function of the thickness the layers of the stack in which the trenches are made, the method being such that first semi-conductor zone has, after step b), a strain of the same type as said pre-strained layer, said second semi-conductor zone having a strain of a type opposite to that of said pre-strained layer.

3. Method according to claim 2, said second semi-conductor zone having a critical dimension $L_9$ less than or equal to the first critical dimension $L_8$.

4. Method according to any of the claims 2 or 3, among said trenches at least one other trench being formed in the continuation of a second side of said first semi-conductor zone, opposite to said first side.

5. Method according to any of the claims 3 or 4, wherein the second semi-conductor zone ($109_1$, $309_1$, $409_1$) rests on a block ($B_2$, $B_{10}$, $B_{200}$) etched at step b) in said stack, with at least two of said trenches situated on either side of said etched block.

6. Method according to claim 5, said etched block ($B_2$, $B_{10}$, $B_{200}$) having a critical dimension (D2) greater than the depth of said trenches.

7. Method according to any of the claims 1 to 6, said pre-strained layer being based on a dielectric material such as $Si_3N_4$.

8. Method according to any of the claims 1 to 7, said stack comprising an adhesion layer ($102_3$) between the pre-strained layer ($102_2$) and the semi-conductor layer (103).

9. Method according to any of the claims 1 to 8, said pre-strained layer ($102_2$) being situated on a layer of dielectric material ($102_1$) resting on a semi-conductor support layer (101).

10. Method according to any of the claim 1 to 9, further comprising: the filling of the trenches by means of an insulating material (145).

11. Method according to any of the claims 1 to 10, further comprising: forming on one or several or on all of said semi-conductor zones at least one gate dielectric zone and at least one gate on the gate dielectric zone.

12. Method according to any of the claims 1 to 11, wherein the pre-strained layer is tensile strained, the first semi-conductor zone being tensile strained, the second semi-conductor zone being compressive strained.

13. Method according to any of the claims 1 to 12, the depth of the trenches being equal to half of the critical dimension $L_8$ of said first semi-conductor zone.

FIG. 1A

FIG. 1B

FIG. 1C

FIG. 2

FIG. 3

FIG. 4

FIG. 5

FIG. 6A

C2

← 100 nm → ← 100 nm →

C3

20 nm

-2208    -800    -400    0
    -1000    -600    -200

# FIG. 6B

Axe de symétrie

← 50 nm → ← 50 nm →

-2191    -400    0    100    200
    -600    -200    50    150

# FIG. 7

FIG. 8A

FIG. 8B

FIG. 8C

FIG. 8D

510            520
              508
              $502_3$
              $50_{22}$
              $50_{21}$

## FIG. 9A

510            520
              513
              $50_{22}$
              $50_{21}$

## FIG. 9B

FIG. 10

## RÉFÉRENCES CITÉES DANS LA DESCRIPTION

**Documents brevets cités dans la description**

- US 7262087 B2
- US 7223994 B2
- US 7091095 B2

**Littérature non-brevet citée dans la description**

- **HU et al.** *Appl. Phys.,* Juillet 1979, vol. 50 (7), 4661
- **HU et al.** *Appl. Phys.,* Septembre 1991, vol. 70 (6), R53